# EUROPEAN PATENT APPLICATION

(11) **EP 2 298 715 A1**
(43) Date of publication of application: **23.03.2011**
(21) Application number: 09794307.0
(22) Date of filing: 23.06.2009
(51) Int. Cl.: C04B 35/50, C04B 35/00, C23C 14/34

(54) **LANTHANUM OXIDE-BASED SINTERED OBJECT, SPUTTERING TARGET COMPRISING THE SINTERED OBJECT, PROCESS FOR PRODUCING LANTHANUM OXIDE-BASED SINTERED OBJECT, AND PROCESS FOR SPUTTERING TARGET PRODUCTION USING THE PROCESS**

(30) Priority: 07.07.2008 JP 2008176538
(71) Applicant: JX Nippon Mining & Metals Corporation, Tokyo 100-8164 (JP)
(72) Inventor: SATOH Kazuyuki, Kitaibaraki-shi Ibaraki 319-1535 (JP); KOIDO Yoshimasa, Kitaibaraki-shi Ibaraki 319-1535 (JP)
(74) Representative: Hoarton, Lloyd Douglas Charles
(86) International application number: PCT/JP2009/061352
(87) International publication number: WO 2010/004861

(57) **Abstract**

A lanthanum oxide-based sintered compact having lanthanum oxide as a basic component, wherein the sintered compact contains one or more of titanium oxide, zirconium oxide and hafnium oxide with the remainder being lanthanum oxide and unavoidable impurities. A method of producing a lanthanum oxide-based sintered compact, wherein La₂(CO₃)₃ powder or La₂O₃ powder as lanthanum oxide raw material powder and one or more of TiO₂, ZrO₂ and HfO₂ powders as an additive oxide are used, blending and mixing are performed so that the composition ratio of metal components of the additive oxide becomes a predetermined value based on the metal conversion, the mixed powder is thereafter heated and synthesized in the atmosphere, the synthesized material is subsequently pulverized to obtain powder, and the synthesized powder is thereafter hot pressed into a sintered compact. This invention prevents the sintered compact from combining with moisture or carbon dioxide gas to form hydroxide or the like and changing into powder form, and enables the long term storage thereof. Moreover, as a result of performing deposition with this sputtering target, oxide for use in a high-k gate insulator film can be efficiently and stably provided.

## Description

### TECHNICAL FIELD

The present invention relates to a lanthanum oxide-based sintered compact having lanthanum (La) oxide as a basic component and containing an additive oxide of one or more of titanium (Ti), zirconium (Zr), and hafnium (Hf); a sputtering target composed of the foregoing sintered compact; a method of producing the lanthanum oxide-based sintered compact; and a method of producing the sputtering target based on the foregoing production method.

### BACKGROUND ART

In recent years, thinning of a gate insulator film in the next-generation MOSFET is being demanded, but with the SiO₂ that has been conventionally used as the gate insulator film, the leak current will increase due to the tunnel effect, and normal operation is becoming difficult.

Thus, as a substitute for the SiO₂ described above, so-called high-k materials such as HfO₂, ZrO₂, Al₂O₃ and La₂O₃ with high dielectric constant, high thermal stability, and high energy barrier against the holes and electrons in the silicon have been proposed.

Among the foregoing materials, HfO₂-based materials are considered to be highly promising, and there have been research papers regarding their use as a gate insulator film in the next-generation MOSFET. In recent years, there have been reports that improvement in properties such as lowering the threshold voltage can be achieved by using a combination of a HfO-based or HfON-based high-k material and lanthanum oxide (La₂O₃) (refer to Non Patent Document 1). Moreover, as the LaHfO-based material, there is disclosure on controlling the effective work function of the metal gate electrode with La₂Hf₂O₇ (refer to Patent Document 1).

Accordingly, lanthanum is a material that is attracting attention.

Lanthanum (La) is one of the rare earth elements, and is a mineral resource that is contained in the earth's crust as a mixed composite oxide. Rare-earth elements are so called because they are separated from relatively rare minerals, but they are not that rare in light of the overall earth's crust.

Lanthanum is a white metal having an atomic number of 57 and an atomic weight of 138.9, and comprises a double hexagonal close-packed structure at normal temperature. Lanthanum has a melting point of 921 °C, boiling point of 3500°C, and density of 6.15 g/cm³. Its surface is oxidized in the atmosphere, and gradually melts in water. Lanthanum is soluble in hot water and acid. Although it is not ductile, it is slightly malleable. The resistivity is 5.70 x 10⁻⁶ Ω cm, and it becomes oxide (La₂O₃) when burned at 445°C or higher (refer to Dictionary of Physics and Chemistry).

With rare earth elements, it is generally said that compounds with the oxidation number 3 are stable, and lanthanum is also trivalent.

Metal lanthanum is a material in which high purification is difficult to achieve since it is easily oxidized during the refining process, and a high purity product thereof did not exist to date. In addition, if metal lanthanum is left in the atmosphere, there is a problem in that the handling thereof is difficult since it will become oxidized and darkly-discolored in a short period of time.

It could be said that lanthanum (lanthanum oxide) is still in the research phase, but when studying the properties of such lanthanum (lanthanum oxide), if metal lanthanum metal itself exists as a sputtering target material, it is possible to form a lanthanum thin film on a substrate. It will also be easy to study the behavior at the interface with the silicon substrate, and additionally study the properties of a high-dielectric gate insulator film or the like by forming a lanthanum compound, and there is also a significant advantage in that the freedom of the target as a product will increase.

Nevertheless, even if a lanthanum sputtering target is prepared, as described above, it becomes oxidized in a short period of time (approximately 10 minutes) in the atmosphere. When an oxide film is formed on the target, the electrical conductivity will deteriorate and thereby cause defective sputtering. In addition, if the lanthanum sputtering target is left in the atmosphere for a long period of time, it reacts with the moisture in the air and becomes covered with white hydroxide powder, and it may even cause a problem of not allowing normal sputtering to be performed.

Thus, after the target is prepared, it is necessary to immediately take oxidation prevention measures such as vacuum packing or covering the target with fats and oils, but to perform vacuum pack as needed entails considerably troublesome work. Similarly, if the sputtering target is covered with fats and oils, this will entail the work of eliminating such fats and oils since a sputtering target is demanded of cleanliness, and this will similarly entail considerably troublesome work.

In light of the foregoing problems, the current status is that a target material made of the lanthanum element has not yet been put into practical application. As described above, it was not possible to produce a lanthanum oxide target capable of withstanding practical application.

Meanwhile, in order to form a lanthanum oxide film, deposition with a uniform oxygen amount can be realized with a simpler process by using a lanthanum oxide target in comparison to the method of performing reactive sputtering of metal lanthanum and oxygen, or the method of performing oxidization after the deposition of metal lanthanum. Nevertheless, lanthanum oxide reacts with moisture in the air faster than metal lanthanum, becomes pulverized in an extremely short period of time, and will eventually become completely decayed. Accordingly, if the La₂O₃ film is to be prepared with the PVD method, in particular the sputtering method, which is an industrially standard method, it is extremely difficult to supply a sputtering target capable of withstanding practical application.
[Non Patent Document 1] Written by ALSHAREEF H.N., QUEVEDO-LOPEZ M., WEN H.C., HARRIS R., KIRSCH P., MAJHI P., LEE B.H., JAMMY R., "Work function engineering using lanthanum oxide interfacial layers" Appl. Phys. Lett., Vol. 89 No. 23 Pages 232103-232103-3, (2006)
[Patent Document 1] Japanese Laid-Open Patent Publication No. 2007-324593

### DISCLOSURE OF THE INVENTION

As described in the foregoing conventional technology, since metal lanthanum easily combines with oxygen, and lanthanum oxide combines with moisture and carbon dioxide gas, to form a hydroxide or the like and change into powder form, these are difficult to store for a long period of time and difficult to commercialize as a sputtering target.

The present invention provides a lanthanum oxide-based sintered compact having lanthanum (La) oxide as a basic component and containing an additive oxide of one or more of titanium (Ti), zirconium (Zr), and hafnium (Hf); a sputtering target composed of the foregoing sintered compact; a method of producing the lanthanum oxide-based sintered compact; and a method of producing the sputtering target based on the foregoing production method. It is thereby possible to prevent the sintered compact and the target from combining with moisture or carbon dioxide gas to form hydroxide or the like and changing into powder form, and enables the long term storage thereof. Moreover, the aim is to efficiently and stably provide oxide for use in a high-k gate insulator film by performing deposition with this sputtering target.

As described in the foregoing paragraph, metal lanthanum easily combines with oxygen, and lanthanum oxide combines with moisture and carbon dioxide gas to form a hydroxide, and both are difficult to store for a long period of time. The present invention uses lanthanum oxide as the basic component and adds one or more of titanium oxide, zirconium oxide and hafnium oxide thereto in order to obtain a sintered compact or a sputtering target. The component composition of such sintered compact and target includes new substances.

Based on the foregoing discovery, the present invention provides:
1) A lanthanum oxide-based sintered compact having lanthanum oxide as a basic component, wherein the sintered compact contains one or more of titanium oxide, zirconium oxide and hafnium oxide, and remainder is lanthanum oxide and unavoidable impurities;
2) The lanthanum oxide-based sintered compact according to 1) above, wherein the amount of metal elements of titanium, zirconium and hafnium relative to the total component amount of metal elements in the sintered compact is 1 mol% or more and less than 50 mol%;
3) The lanthanum oxide-based sintered compact according to 1) above, wherein the amount of metal elements of titanium, zirconium and hafnium relative to the total component amount of metal elements in the sintered compact is 10 mol% or more and less than 50 mol%;
4) The lanthanum oxide-based sintered compact according to any one of 1) to 3) above, wherein hydrogen and carbon contents are respectively 25 wtppm or less, relative density is 96% or higher, maximum grain size is 50 µm or less, and average grain size is 5 µm or more; and
5) A sputtering target composed of the sintered compact according to any one of 1) to 4) above.

The present invention additionally provides:
6) A method of producing a lanthanum oxide-based sintered compact, wherein La₂(CO₃)₃ powder or La₂O₃ powder as lanthanum oxide raw material powder, and one or more of TiO₂, ZrO₂ and HfO₂ powders as an additive oxide are used, blending and mixing are performed so that the composition ratio of metal components of the additive oxide relative to La becomes a predetermined value, the mixed powder is thereafter heated and synthesized in the atmosphere, the synthesized material is subsequently pulverized to obtain powder, and the synthesized powder is thereafter hot pressed into a sintered compact;
7) A method of producing the lanthanum oxide-based sintered compact according to any one of 1) to 5) above, wherein La₂(CO₃)₃ powder or La₂O₃ powder as lanthanum oxide raw material powder, and one or more of TiO₂, ZrO₂ and HfO₂ powders as an additive oxide are used, blending and mixing are performed so that the composition ratio of metal components of the additive oxide relative to La becomes a predetermined value, the mixed powder is thereafter heated and synthesized in the atmosphere, the synthesized material is subsequently pulverized to obtain powder, and the synthesized powder is thereafter hot pressed into a sintered compact;
8) The method of producing the lanthanum oxide-based sintered compact according to 6) or 7) above, wherein the mixing is performed with a wet ball mill, and synthesys is performed by heating the mixed powder at 1350 to 1550°C for 5 to 25 hours in the atmosphere to produce the sintered compact;
9) The method of producing the lanthanum oxide-based sintered compact according to any one of 6) to 8) above, when the hot press is performed at 1200 to 1500°C in vacuum for 1 to 5 hours; and
10) A method of producing a sputtering target based on the method of producing the lanthanum oxide-based sintered compact according to any one of 6) to 8) above.

If a sputtering target of lanthanum oxide sintered compact is left out in the air for a long period of time, it reacts with moistures due to deliquescency and becomes covered with white hydroxide powder, and there is a problem in that normal sputtering cannot be performed. Moreover, it absorbs the carbon dioxide gas in the air and decays into the form of lanthanum carbonate powder. The target of the present invention enables to delay the occurrence of the foregoing problems, and can be stored for a period that will not cause problems in terms of practical use.

As the additive oxide, titanium oxide, zirconium oxide and hafnium oxide are all effective as a high-k material, but in particular the material added with Hf oxide, which is used as a HfO-based, HfON-based, HfSiO-based or HfSiON-based material (high-k material), is even more effective in comparison to those containing titanium oxide or zirconium oxide since the increase in the leak current, which is associated with the diffusion of titanium or zirconium to the high-k material side, is low.

### BEST MODE FOR CARRYING OUT THE INVENTION

The sputtering target of oxide sintered compact according to the present invention is a sputtering target which uses a sintered compact having lanthanum oxide as a basic component, and containing one or more of titanium oxide, zirconium oxide and hafnium oxide with the remainder being lanthanum oxide and unavoidable impurities.

The foregoing sintered compact and target yield significant effects of being able to considerably inhibit, in comparison to lanthanum or lanthanum oxide, the phenomenon of reacting with moisture due to deliquescency to be covered with white hydroxide powder and decay, or the phenomenon of absorbing the carbon dioxide gas in the air and decaying into lanthanum carbonate powder. This is the main technical concept of the present invention. Among the conventional technologies searched by the present applicant, there is no sintered compact or target with the foregoing composition.

Although the logic of inhibiting the decay of lanthanum or lanthanum oxide is not necessarily clear, it is evident from the numerous experiments that the addition of titanium oxide, zirconium oxide and hafnium oxide as additive components is a significant contribution of such inhibition. This is explained in detail with reference to the Examples and Comparative Examples described later.

Since the addition of titanium oxide, zirconium oxide and hafnium oxide is not the independent use of lanthanum or lanthanum oxide, there are restrictions in the use of the material. Nevertheless, since all of these materials can be effectively used as an oxide for a high-k gate insulator film, the addition itself will not generate any negative effect.

The additive amount thereof may be selected based on the purpose of use and intended usage. Among the above, the addition of hafnium oxide is particularly effective as the oxide for use in a high-k gate insulator film. This is because when titanium oxide or zirconium oxide is used, trace amounts of titanium or zirconium are diffused to the high-k material side, and there is a problem in that the leak current increases slightly. Hafnium oxide is free from this problem.

When considering lanthanum (La), and the addition of the oxides of titanium (Ti), zirconium (Zr) and hafnium (Hf), it is preferable that the amount of the metal components of the additive oxides (total of titanium, zirconium and hafnium) relative to the total amount of La and the metal components of the additive oxides (total of titanium, zirconium and hafnium) in the oxide, namely (Ti, Zr, Hf)/(La + Ti, Zr, Hf), is 1 mol% or more and less than 50 mol%. 10 mol% or more is even more preferably to prevent the decay more effectively.

If it is less than 1 mol%, there is little effect in preventing the decay of lanthanum oxide caused by deliquescency. If it is 50 mol% or more, although it is effective in preventing the decay, there is little effect obtained by using the characteristics as the lanthanum oxide. For example, if more Hf is contained, characteristics of high-dielectric oxides (for example, La₂Hf₂O₇, La₂Zr₂O₇) will prevail, and the characteristics will become different.

The present invention is on the premise of being used as a high-k material, and aims to obtain characteristics such as lowering the threshold voltage by combining lanthanum oxide (La₂O₃) in its use.

Moreover, as additional requirements, the reduction of the hydrogen content and carbon content in the sintered compact, improvement of the density, and achievement of an optimal crystal grain size are also effective in further improving the characteristics of the sintered compact and target of the present invention. In order to achieve this object, the present invention provides a lanthanum oxide-based sintered compact and target in which hydrogen and carbon contents are respectively 25 wtppm or less, relative density is 96% or higher, maximum grain size is 50 µm or less, and average grain size is 5 µm or more and 20 µm or less.

It is effective to reduce the existence of hydrogen and carbon in the sintered compact and target since they become the source of causing reaction with moisture and carbon dioxide gas in the atmosphere. Moreover, the improvement of density is required in order to reduce the contact area with the atmosphere. The density is more preferably 98%. Consequently, through-pores in the sintered compact can be reduced and decaying from the inside can be prevented.

It is also possible to relatively enlarge the crystal grain size of the sintered compact in order to reduce the grain boundary, and thereby reduce the decay from the grain boundary. Since the grain boundary area will decrease if the crystal grain size is enlarged as described above, this is effective in reducing the decay from the grain boundary. However, if the crystal grain size is enlarged excessively, the improvement of density becomes difficult, and it could be said that the maximum grain size of 50 µm or less is preferably in order to improve the density.

Nevertheless, it goes without saying that these are all preferably additional requirements, and the present invention is not bound by these conditions.

Upon producing this target of oxide sintered compact, La₂(CO₃)₃ powder or La₂O₃ powder as raw material powder, and one or more of TiO₂, ZrO₂ and HfO₂ powders as an additive oxide are used. Blending is performed so that the total amount of titanium, zirconium and hafnium as metal components in the additive oxide relative to the grand total amount of the metal La, and titanium, zirconium and hafnium as metal components in the additive oxide becomes 1 mol% or more and less than 50 mol%. This blend ratio is more preferably 10 mol% or more and less than 50 mol%.

However, if oxides can be achieved based on heat treatment or the like, the present invention is not limited to the foregoing oxides. For example, as such raw materials with respect to La, there are lanthanum hydroxide, lanthanum nitrate, lanthanum chloride and the like. Moreover, if sufficient management is possible, metal lanthanum may also be used.

With respect to Ti, Zr and Hf, if sufficient management is possible, metal powder or hydrogenated powder with favorable grindability may also be used. After mixing the foregoing powders, they are heated and synthesized in an oxygen atmosphere, the synthesized material is subsequently pulverized to obtain powder, and the synthesized powder is further hot pressed to obtain a sintered compact.

When using hydrogenated powder (titanium hydride, zirconium hydride, hafnium hydride) as the raw material, it is necessary to sufficiently perform dehydrogenation treatment in a vacuum atmosphere or an inert gas atmosphere.

The recommended production conditions are to perform the mixing using a wet ball mill, and to perform the synthesis by heating the powder at 1350 to 1550°C for 5 to 25 hours in the atmosphere.

Moreover, to perform the hot press at 1200 to 1500°C in vacuum for 1 to 5 hours is also the recommended production conditions as the sintering conditions. The foregoing conditions are for efficiently performing the synthesis and sintering. Accordingly, it should be understood that the adoption of other conditions and the addition of other conditions can be performed as a matter of course.

It is thereby possible to obtain a sputtering target of oxide sintered compact with a relative density of 96% or higher, more preferably 98% or higher, a maximum grain size of 50 µm or less, and more preferably an average grain size of 5 µm or more and 20 µm or less. The improvement of density and the refinement of crystal grain size enable to inhibit the generation of nodules and particles, and it goes without saying that these are preferred conditions for performing uniform deposition.

Generally speaking, the rare earth elements contained in lanthanum include Sc, Y, Ce, Pr, Nd, Pm, Sm, Eu, Gd, Tb, Dy, Ho, Er, Tm, Yb, and Lu other than lanthanum (La), but it is difficult to separate and refine these elements from La since they have similar properties. In particular, since Ce is approximate to La, it is difficult to reduce Ce.

Nevertheless, since these rare earth elements have approximate properties, it should be understood there is no particular problem so as long as the total amount of rare earth elements is less than 1000 wtppm. Accordingly, the use of lanthanum in the present invention tolerates the inclusion of the foregoing level of rare earth elements as unavoidable impurities.

In addition to the above, there are impurities that get inevitably mixed in. For example, Ti, Zr and Hf have similar chemical properties, and it is known that the separation of Zr and Hf is difficult. Trace amounts of Zr get mixed into Hf. Moreover, trace amounts of Hf also get mixed into Zr, but both of these situations do not cause a major problem. Nevertheless, in order to clearly leverage the characteristics of the added Hf (hafnium oxide), it goes without saying that the reduction of Zr that gets inevitably mixed in is also preferable. This is because, as described above, Zr may be diffused in the Hf-based HfO, HfON, HfSiO or HfSiON as the high-k (high-dielectric) material and change the dielectric constant.

However, since the present invention aims to obtain a practical sputtering target by inhibiting the decay of lanthanum oxide, it covers the foregoing unavoidable impurities. Moreover, with respect to the purity level, the purity is preferably 3N or higher excluding the foregoing special unavoidable impurities and excluding gas components.

Generally speaking, C, N, O, S and H exist as gas components. In the case of lanthanum oxide, it is important to reduce C and H. Since C and H each promote the reaction with carbon dioxide gas and moisture in a storage atmosphere, and since they also react with their own oxygen and the oxygen in the atmosphere to form lanthanum carbonate and lanthanum hydroxide and decay into powder form; the reduction thereof is important. Thus, it is more preferable to perform sintering in vacuum or inert gas based on hot pressing rather than sintering in an oxygen (ambient) atmosphere.

### [Examples]

Examples of the present invention are now explained. Incidentally, these Examples are merely for facilitating the understanding of the invention, and the present invention shall in no way be limited thereby. In other words, various modifications and other embodiments based on the technical spirit claimed in the claims shall be covered by the present invention as a matter of course. Note that the Reference Examples described below are those which are insufficient in light of the object of the present invention, but show similar improvements in characteristics as the present invention. Comparative Example 1 is described in rearmost paragraph [0054].

### (Reference Examples 1 to 3, Examples 1 to 25)

La₂(CO₃)₃ powder, and HfO₂, ZrO₂ and TiO₂ powders were used as the raw material powders, these were blended so that the amount of Hf, Zr and Ti relative to the total amount of metal components including La will be 0.5 to 49 mol%, and subsequently mixed with a wet ball mill. The mixed powder was heated and synthesized in the atmosphere at 1450°C for 20 hours.

The synthesized material was subject to wet grinding in a ball mill for 16 hours to obtain powder. The synthesized powder was hot pressed in vacuum at 1400°C for 2 hours to obtain a sintered compact. The size of the sintered compact was φ 80 mm, and the working pressure was 300 kg/cm².

Note that, since the results were the same in cases of using La₂O₃ powder as the La oxide, the cases of using the La₂(CO₃)₃ powder are explained in the Examples.

The sintered compact was machined to obtain a sintered compact for evaluation. The sintered compact was a composite oxide of the foregoing oxides. The stability of the sintered compact for evaluation was examined in the atmosphere or a constant temperature and humidity vessel (temperature 40°C, and humidity 90%). Those in powder form were confirmed, based on XRD, to mainly be lanthanum hydroxide (La(OH)₃).

The sintered compact shown in the Examples can be bonded to a backing plate as a target, and be subject to vacuum sealing (or in an inert gas atmosphere) as needed, and it can actually be used in the semiconductor manufacture process.

Note that the mixing conditions, synthesizing conditions and hot press conditions of the foregoing raw material powder are all representative conditions. The preferred conditions shown in paragraph [0011] can be arbitrarily selected.

### (Reference Example 1)

The composite oxide sintered compact of Reference Example 1 contained 0.5 mol% of hafnium based on the metal conversion of the composite oxide sintered compact (lanthanum oxide and hafnium oxide); that is, contained 0.5% of Hf based on the mol% of Hf/(La + Hf). The same applies to the other Reference Examples and Examples shown below. Note that, by way of reference, 50 mol% achieves the composition of La₂Hf₂O₇, wherein it is 33.3 mol% for La₂O₃, and 66.7 mol% for HfO₂.

The carbon content was 35 ppm, hydrogen content was 29 ppm, relative density was 95%, maximum grain size was 41 µm, and average grain size was 12 µm. In the foregoing case, the HfO₂ amount was slightly lower than the preferred conditions of the present invention, the carbon content was slightly more than the preferred conditions of the present invention, and the relative density was slightly low at 95%. Consequently, the sintered compact decayed into powder form after being left in the atmosphere for 3 weeks.

Nevertheless, in a vacuum pack, no pulverization of the surface was acknowledged until the lapse of 4 months. It can be said that a sintered compact of this level is subject to a slightly faster decay rate, but is within a range of practical level if a vacuum pack is used. The evaluation was "Δ" (average).

### (Reference Example 2)

The composite oxide sintered compact of Reference Example 2 contained 0.5 mol% of ZrO₂ through Zr conversion based on metal conversion. The carbon content was 23 ppm, hydrogen content was 19 ppm, relative density was 97%, maximum grain size was 37 µm, and average grain size was 9 µm. In the foregoing case, although the ZrO₂ amount was slightly less than the preferred conditions of the present invention, the relative density was slightly high at 97%. Consequently, the sintered compact decayed into powder form after being left in the atmosphere for 4 weeks. There was slight improvement in comparison to Reference Example 1.

Nevertheless, in a vacuum pack, no pulverization of the surface was acknowledged until the lapse of 4 months. It can be said that a sintered compact of this level is subject to a slightly faster decay rate, but is within a range of practical level if a vacuum pack is used. The evaluation was "Δ" (average).

### (Reference Example 3)

The composite oxide sintered compact of Reference Example 3 contained 0.5 mol% of TiO₂ through Ti conversion based on metal conversion. The carbon content was 46 ppm, hydrogen content was 50 ppm, relative density was 95%, maximum grain size was 53 µm, and average grain size was 11 µm. In the foregoing case, the TiO₂ was slightly less than the preferred conditions of the present invention, the carbon content and hydrogen content were slightly more than the preferred conditions of the present invention, the maximum grain size was slightly large at 53 µm, and the relative density was slightly low at 95%. Consequently, the sintered compact decayed into powder form after being left in the atmosphere for 3 weeks.

Nevertheless, in a vacuum pack, no pulverization of the surface was acknowledged until the lapse of 4 months. It can be said that a sintered compact of this level is subject to a slightly faster decay rate, but is within a range of practical level if a vacuum pack is used. The evaluation was "Δ" (average).

### (Example 1)

The composite oxide sintered compact of Example 1 contained 1 mol% of HfO₂ through Hf conversion based on metal conversion. The carbon content was 37 ppm, hydrogen content was 30 ppm, relative density was 95%, maximum grain size was 40 µm, and average grain size was 10 µm. In the foregoing case, the HfO₂ amount was within the scope of the preferred conditions of the present invention. The carbon content and hydrogen content were slightly more than the preferred conditions of the present invention, and the relative density was slightly low at 95%.

Consequently, the sintered compact decayed into powder form in the 4^{th} week in a vessel with constant temperature (40°C) and constant humidity (90%) in the acceleration test. Moreover, in a vacuum pack, no pulverization of the surface was acknowledged during a 6 month period. It has been confirmed that the existence of HfO₂ yields a significant effect of inhibiting the decay of the sintered compact. The sintered compact was of a practical level and the evaluation was "O" (good).

### (Example 2)

The composite oxide sintered compact of Example 2 contained 1 mol% of HfO₂ through Hf conversion based on metal conversion. The carbon content was 15 ppm, hydrogen content was 20 ppm, relative density was 97%, maximum grain size was 42 µm, and average grain size was 15 µm. In the foregoing case, all conditions were within the scope of the preferred conditions of the present invention.

Consequently, the sintered compact decayed into powder form in the 4^{th} week in a vessel with constant temperature (40°C) and constant humidity (90%) in the acceleration test. Moreover, in a vacuum pack, no pulverization of the surface was acknowledged during a 10 month period. It has been confirmed that the existence of HfO₂ and optimization of the additional conditions yield a significant effect of inhibiting the decay of the sintered compact. The sintered compact was of a practical level and the evaluation was "O" (good).

### ] (Example 3)

The composite oxide sintered compact of Example 3 contained 5 mol% of HfO₂ through Hf conversion based on metal conversion. The carbon content was 53 ppm, hydrogen content was 47 ppm, relative density was 97%, maximum grain size was 41 µm, and average grain size was 5 µm. In the foregoing case, the carbon content and hydrogen content were high, but the other conditions were within the scope of the preferred conditions of the present invention.

Consequently, the sintered compact decayed into powder form in the 4^{th} week in a vessel with constant temperature (40°C) and constant humidity (90%) in the acceleration test. Moreover, in a vacuum pack, no pulverization of the surface was acknowledged during a 6 month period. It has been confirmed that the existence of excessive carbon and hydrogen in the composite oxide sintered compact becomes a factor to rather facilitate the decay. Nevertheless, on the whole, it has been confirmed that the composite oxide sintered compact of Example 3 yields a significant effect of inhibiting decay. The sintered compact was of a practical level and the evaluation was "O" (good).

### (Example 4)

The composite oxide sintered compact of Example 4 contained 5 mol% of HfO₂ through Hf conversion based on metal conversion. The carbon content was 26 ppm, hydrogen content was 28 ppm, relative density was 98%, maximum grain size was 36 µm, and average grain size was 13 µm. In the foregoing case, the carbon content and hydrogen content in the composite oxide sintered compact existed somewhat excessively, but the amounts thereof were less than Example 6.

Consequently, only the surface of the sintered compact decayed into powder form in the 4^{th} week in a vessel with constant temperature (40°C) and constant humidity (90%) in the acceleration test. Moreover, in a vacuum pack, no pulverization of the surface was acknowledged during a 10 month period.

It has been confirmed that the slightly excessive existence of carbon and hydrogen in the composite oxide sintered compact becomes a factor to rather facilitate the decay. Nevertheless, it has been confirmed that the composite oxide sintered compact of Example 4 yielded a greater effect of inhibiting decay than Example 6. The sintered compact was of a practical level and the evaluation was "O" (good).

### (Example 5)

The composite oxide sintered compact of Example 5 contained 10 mol% of HfO₂ through Hf conversion based on metal conversion. The carbon content was 76 ppm, hydrogen content was 28 ppm, relative density was 95%, maximum grain size was 63 µm, and average grain size was 3 µm. In the foregoing case, the carbon content and hydrogen content in the composite oxide sintered compact existed excessively, and the additional conditions of maximum grain size and average grain size were not within the optimal range.

Consequently, no decay of the sintered compact into powder form could be acknowledged even in the 8^{th} week in a vessel with constant temperature (40°C) and constant humidity (90%) in the acceleration test. However, upon measuring the hardness of the surface, there was tendency of some deterioration.

Moreover, in a vacuum pack, pulverization of the surface was finally acknowledged after the lapse of 1 year. This composite oxide sintered compact contained a large amount of Hf, and it has been confirmed that a significant effect of inhibiting decay is yielded even if the other additional factors are outside of the conditions of the present invention. The evaluation was "Ⓞ" (excellent).

### (Example 6)

The composite oxide sintered compact of Example 6 contained 10 mol% of HfO₂ through Hf conversion based on metal conversion. The carbon content was 18 ppm, hydrogen content was 20 ppm, relative density was 96%, maximum grain size was 23 µm, and average grain size was 15 µm. In the foregoing case, all conditions of the composite oxide sintered compact were within the scope of the preferred conditions of the present invention.

Consequently, no decay of the sintered compact into powder form could be acknowledged even in the 8^{th} week in a vessel with constant temperature (40°C) and constant humidity (90%) in the acceleration test. Moreover, in a vacuum pack, no pulverization was acknowledged even after the lapse of 1 year. It has been confirmed that when the existence of Hf and the additional factors are within the conditions of the present invention as with this composite oxide sintered compact, a significant effect of inhibiting decay is yielded. The evaluation was "⊚" (excellent).

### (Example 7)

The composite oxide sintered compact of Example 7 contained 35 mol% of HfO₂ through Hf conversion based on metal conversion. The carbon content was 73 ppm, hydrogen content was 52 ppm, relative density was 98%, maximum grain size was 37 µm, and average grain size was 8 µm. In the foregoing case, the carbon content and hydrogen content were considerably high, but the additional conditions were within the optical range.

Consequently, no decay of the sintered compact into powder form could be acknowledged even in the 8^{th} week in a vessel with constant temperature (40°C) and constant humidity (90%) in the acceleration test. However, upon measuring the hardness of the surface, there was tendency of some deterioration.

Moreover, in a vacuum pack, pulverization of the surface was finally acknowledged after the lapse of 1 year. However, upon measuring the hardness of the surface, there was tendency of some deterioration.

It has been confirmed that when the existence of Hf and the additional factors are within the conditions of the present invention as with this composite oxide sintered compact, a significant effect of inhibiting decay is yielded. The evaluation was "Ⓞ" (excellent).

### (Example 8)

The composite oxide sintered compact of Example 8 contained 35 mol% of HfO₂ through Hf conversion based on metal conversion. The carbon content was 13 ppm, hydrogen content was 21 ppm, relative density was 98%, maximum grain size was 30 µm, and average grain size was 13 µm. In the foregoing case, all conditions of the composite oxide sintered compact were within the scope of the preferred conditions of the present invention.

Consequently, no decay of the sintered compact into powder form could be acknowledged even in the 8^{th} week in a vessel with constant temperature (40°C) and constant humidity (90%) in the acceleration test. Moreover, in a vacuum pack, no pulverization was acknowledged even after the lapse of 1 year. It has been confirmed that when the existence of Hf and the additional factors are within the conditions of the present invention as with this composite oxide sintered compact, a significant effect of inhibiting decay is yielded. The evaluation was "Ⓞ" (excellent).

### (Example 9)

The composite oxide sintered compact of Example 9 contained 45 mol% of HfO₂ through Hf conversion based on metal conversion. The carbon content was 73 ppm, hydrogen content was 52 ppm, relative density was 98%, maximum grain size was 37 µm, and average grain size was 8 µm. In the foregoing case, the carbon content and hydrogen content were considerably high, but the additional conditions were within the optical range.

Consequently, no decay of the sintered compact into powder form could be acknowledged even in the 8^{th} week in a vessel with constant temperature (40°C) and constant humidity (90%) in the acceleration test. However, upon measuring the hardness of the surface, there was tendency of some deterioration.

Moreover, in a vacuum pack, pulverization of the surface was finally acknowledged after the lapse of 1 year. It has been confirmed that when the existence of Hf and the additional factors are within the conditions of the present invention as with this composite oxide sintered compact, a significant effect of inhibiting decay is yielded. The evaluation was "Ⓞ" (excellent).

### (Example 10)

The composite oxide sintered compact of Example 10 contained 45 mol% of HfO₂ through Hf conversion based on metal conversion. The carbon content was 10 ppm, hydrogen content was 25 ppm, relative density was 98%, maximum grain size was 31 µm, and average grain size was 14 µm. In the foregoing case, all conditions of the composite oxide sintered compact were within the scope of the preferred conditions of the present invention.

Consequently, no decay of the sintered compact into powder form could be acknowledged even in the 8^{th} week in a vessel with constant temperature (40°C) and constant humidity (90%) in the acceleration test. Moreover, in a vacuum pack, no pulverization was acknowledged even after the lapse of 1 year. It has been confirmed that when the existence of Hf and the additional factors are within the conditions of the present invention as with this composite oxide sintered compact, a significant effect of inhibiting decay is yielded. The evaluation was "Ⓞ" (excellent).

### (Example 11)

The composite oxide sintered compact of Example 11 contained 48 mol% of HfO₂ through Hf conversion based on metal conversion. The carbon content was 23 ppm, hydrogen content was 24 ppm, relative density was 97%, maximum grain size was 18 µm, and average grain size was 10 µm. In the foregoing case, all conditions of the composite oxide sintered compact were within the scope of the preferred conditions of the present invention.

Consequently, no decay of the sintered compact into powder form could be acknowledged even in the 8^{th} week in a vessel with constant temperature (40°C) and constant humidity (90%) in the acceleration test. Moreover, in a vacuum pack, no pulverization was acknowledged even after the lapse of 1 year. It has been confirmed that when the existence of Hf and the additional factors are within the conditions of the present invention as with this composite oxide sintered compact, a significant effect of inhibiting decay is yielded. The evaluation was "Ⓞ" (excellent).

### (Example 12)

The composite oxide sintered compact of Example 12 contained 5 mol% of ZrO₂ through Zr conversion based on metal conversion. The carbon content was 20 ppm, hydrogen content was 14 ppm, relative density was 98%, maximum grain size was 20 µm, and average grain size was 12 µm. In the foregoing case, all conditions of the composite oxide sintered compact were within the scope of the preferred conditions of the present invention.

Consequently, only the surface of the sintered compact decayed into powder form in the 4^{th} week in a vessel with constant temperature (40°C) and constant humidity (90%) in the acceleration test. Moreover, in a vacuum pack, pulverization of the surface was acknowledged only after the lapse of 10 months. It has been confirmed that when the existence of Zr and the additional factors are within the conditions of the present invention as with this composite oxide sintered compact, an effect of inhibiting decay is yielded. The evaluation was "O" (good).

### ] (Example 13)

The composite oxide sintered compact of Example 13 contained 25 mol% of ZrO₂ through Zr conversion based on metal conversion. The carbon content was 23 ppm, hydrogen content was 15 ppm, relative density was 98%, maximum grain size was 19 µm, and average grain size was 11 µm. In the foregoing case, all conditions of the composite oxide sintered compact were within the scope of the preferred conditions of the present invention.

Consequently, no decay of the sintered compact into powder form could be acknowledged even in the 8^{th} week in a vessel with constant temperature (40°C) and constant humidity (90%) in the acceleration test. Moreover, in a vacuum pack, no pulverization was acknowledged even after the lapse of 1 year. It has been confirmed that when the existence of Zr and the additional factors are within the conditions of the present invention as with this composite oxide sintered compact, an effect of inhibiting decay is yielded. The evaluation was "Ⓞ" (excellent).

### (Example 14)

The composite oxide sintered compact of Example 14 contained 48 mol% of ZrO₂ through Zr conversion based on metal conversion. The carbon content was 73 ppm, hydrogen content was 65 ppm, relative density was 99%, maximum grain size was 17 µm, and average grain size was 3 µm. In the foregoing case, although the composite oxide sintered compact had high density, the carbon content and hydrogen content were also high and the grain size was small.

Consequently, no decay of the sintered compact into powder form could be acknowledged even in the 8^{th} week in a vessel with constant temperature (40°C) and constant humidity (90%) in the acceleration test. However, upon measuring the hardness of the surface, there was tendency of some deterioration. Moreover, in a vacuum pack, pulverization of the surface was finally acknowledged after the lapse of 1 year.

It has been confirmed that when the existence of Zr and the additional factors are within the conditions of the present invention as with this composite oxide sintered compact, a significant effect of inhibiting decay is yielded. The evaluation was "Ⓞ" (excellent).

### (Example 15)

The composite oxide sintered compact of Example 15 contained 1 mol% of TiO₂ through Ti conversion based on metal conversion. The carbon content was 37 ppm, hydrogen content was 30 ppm, relative density was 95%, maximum grain size was 40 µm, and average grain size was 10 µm. In the foregoing case, the composite oxide sintered compact had a high oxygen content and hydrogen content, and the relative density was slightly low at 95%.

Consequently, the sintered compact decayed into powder form in the 4^{th} week in a vessel with constant temperature (40°C) and constant humidity (90%) in the acceleration test. Moreover, in a vacuum pack, pulverization of the surface was acknowledged after the lapse of 6 months. As to this composite oxide sintered compact, it has been confirmed that a moderate effect of inhibiting decay is yielded due to the existence of Ti and the additional factors. The evaluation was "○" (good).

### (Example 16)

The composite oxide sintered compact of Example 16 contained 10 mol% of TiO₂ through Ti conversion based on metal conversion. The carbon content was 25 ppm, hydrogen content was 21 ppm, relative density was 98%, maximum grain size was 28 µm, and average grain size was 13 µm. In the foregoing case, all conditions of the composite oxide sintered compact were within the scope of the preferred conditions of the present invention.

Consequently, no decay of the sintered compact into powder form could be acknowledged even in the 8^{th} week in a vessel with constant temperature (40°C) and constant humidity (90%) in the acceleration test. Moreover, in a vacuum pack, no pulverization was acknowledged even after the lapse of 1 year.

It has been confirmed that when the existence of Ti and the additional factors are within the conditions of the present invention as with this composite oxide sintered compact, an effect of inhibiting decay is yielded. The evaluation was "Ⓞ" (excellent).

### (Example 17)

The composite oxide sintered compact of Example 17 contained 30 mol% of TiO₂ through Ti conversion based on metal conversion. The carbon content was 25 ppm, hydrogen content was 21 ppm, relative density was 98%, maximum grain size was 28 µm, and average grain size was 13 µm. In the foregoing case, all conditions of the composite oxide sintered compact were within the scope of the preferred conditions of the present invention.

Consequently, as with Example 16, no decay of the sintered compact into powder form could be acknowledged even in the 8^{th} week in a vessel with constant temperature (40°C) and constant humidity (90%) in the acceleration test. Moreover, in a vacuum pack, no pulverization was acknowledged even after the lapse of 1 year. It has been confirmed that when the existence of Ti and the additional factors are within the conditions of the present invention as with this composite oxide sintered compact, an effect of inhibiting decay is yielded. The evaluation was "⊚" (excellent).

### (Example 18)

The composite oxide sintered compact of Example 18 contained 49 mol% of TiO₂ through Ti conversion based on metal conversion. The carbon content was 19 ppm, hydrogen content was 25 ppm, relative density was 97%, maximum grain size was 20 µm, and average grain size was 11 µm. In the foregoing case, all conditions of the composite oxide sintered compact were within the scope of the preferred conditions of the present invention.

Consequently, as with Example 17, no decay of the sintered compact into powder form could be acknowledged even in the 8^{th} week in a vessel with constant temperature (40°C) and constant humidity (90%) in the acceleration test. Moreover, in a vacuum pack, no pulverization was acknowledged even after the lapse of 1 year.

It has been confirmed that when the existence of Ti and the additional factors are within the conditions of the present invention as with this composite oxide sintered compact, an effect of inhibiting decay is yielded. The evaluation was "Ⓞ" (excellent).

### (Example 19)

The composite oxide sintered compact of Example 19 contained 10 mol% of TiO₂ and ZrO₂ with the ratio set at 1:1 based on the metal conversion of Ti and Zr. The carbon content was 20 ppm, hydrogen content was 23 ppm, relative density was 97%, maximum grain size was 19 µm, and average grain size was 9 µm. In the foregoing case, all conditions of the composite oxide sintered compact were within the scope of the preferred conditions of the present invention.

Consequently, as with Example 18, no decay of the sintered compact into powder form could be acknowledged even in the 8^{th} week in a vessel with constant temperature (40°C) and constant humidity (90%) in the acceleration test. Moreover, in a vacuum pack, no pulverization was acknowledged even after the lapse of 1 year. It has been confirmed that when the existence of metals of Ti and Zr and the additional factors are within the conditions of the present invention as with this composite oxide sintered compact, an effect of inhibiting decay is yielded. The evaluation was "Ⓞ" (excellent).

### (Example 20)

The composite oxide sintered compact of Example 20 contained 30 mol% of TiO₂ and ZrO₂ with the ratio set at 1:1 based on the metal conversion of Ti and Zr. The carbon content was 17 ppm, hydrogen content was 18 ppm, relative density was 97%, maximum grain size was 26 µm, and average grain size was 15 µm. In the foregoing case, all conditions of the composite oxide sintered compact were within the scope of the preferred conditions of the present invention.

Consequently, as with Example 19, no decay of the sintered compact into powder form could be acknowledged even in the 8^{th} week in a vessel with constant temperature (40°C) and constant humidity (90%) in the acceleration test. Moreover, in a vacuum pack, no pulverization was acknowledged even after the lapse of 1 year. It has been confirmed that when the existence of metals of Ti and Zr and the additional factors are within the conditions of the present invention as with this composite oxide sintered compact, an effect of inhibiting decay is yielded. The evaluation was "Ⓞ" (excellent).

### (Example 21)

The composite oxide sintered compact of Example 21 contained 20 mol% of TiO₂ and HfO₂ with the ratio set at 1:1 based on the metal conversion of Ti and Hf. The carbon content was 18 ppm, hydrogen content was 19 ppm, relative density was 97%, maximum grain size was 23 µm, and average grain size was 12 µm. In the foregoing case, all conditions of the composite oxide sintered compact were within the scope of the preferred conditions of the present invention.

Consequently, as with Example 20, no decay of the sintered compact into powder form could be acknowledged even in the 8^{th} week in a vessel with constant temperature (40°C) and constant humidity (90%) in the acceleration test. Moreover, in a vacuum pack, no pulverization was acknowledged even after the lapse of 1 year. It has been confirmed that when the existence of metals of Ti and Hf and the additional factors are within the conditions of the present invention as with this composite oxide sintered compact, an effect of inhibiting decay is yielded. The evaluation was "⊚" (excellent).

### (Example 22)

The composite oxide sintered compact of Example 22 contained 40 mol% of TiO₂ and HfO₂ with the ratio set at 1:1 based on the metal conversion of Ti and Hf. The carbon content was 25 ppm, hydrogen content was 20 ppm, relative density was 97%, maximum grain size was 23 µm, and average grain size was 17 µm. In the foregoing case, all conditions of the composite oxide sintered compact were within the scope of the preferred conditions of the present invention.

Consequently, as with Example 21, no decay of the sintered compact into powder form could be acknowledged even in the 8^{th} week in a vessel with constant temperature (40°C) and constant humidity (90%) in the acceleration test. Moreover, in a vacuum pack, no pulverization was acknowledged even after the lapse of 1 year. It has been confirmed that when the existence of metals of Ti and Hf and the additional factors are within the conditions of the present invention as with this composite oxide sintered compact, an effect of inhibiting decay is yielded. The evaluation was "Ⓞ" (excellent).

### (Example 23)

The composite oxide sintered compact of Example 23 contained 6 mol% of TiO₂, ZrO₂ and HfO₂ with the ratio set at 1:1:1 based on the metal conversion of Ti, Zr and Hf. The carbon content was 53 ppm, hydrogen content was 37 ppm, relative density was 96%, maximum grain size was 48 µm, and average grain size was 3 µm. In the foregoing case, the carbon content and hydrogen content were considerably high and the average grain size was small with this composite oxide sintered compact, but the other conditions were within the optical range.

Consequently, the sintered compact decayed into powder form in the 4^{th} week in a vessel with constant temperature (40°C) and constant humidity (90%) in the acceleration test. Moreover, in a vacuum pack, pulverization of the surface was acknowledged after the lapse of 6 months. The evaluation of this composite oxide sintered compact was "O" (good).

### (Example 24)

The composite oxide sintered compact of Example 24 contained 24 mol% of TiO₂, ZrO₂ and HfO₂ with the ratio set at 1:1:1 based on the metal conversion of Ti, Zr and Hf. The carbon content was 23 ppm, hydrogen content was 24 ppm, relative density was 97%, maximum grain size was 23 µm, and average grain size was 16 µm. In the foregoing case, all conditions of the composite oxide sintered compact were within the scope of the preferred conditions of the present invention.

Consequently, no decay of the sintered compact into powder form could be acknowledged even in the 8^{th} week in a vessel with constant temperature (40°C) and constant humidity (90%) in the acceleration test. Moreover, in a vacuum pack, no pulverization was acknowledged even after the lapse of 1 year. It has been confirmed that when the existence of metals of Ti, Zr and Hf and the additional factors are within the conditions of the present invention as with this composite oxide sintered compact, an effect of inhibiting decay is yielded. The evaluation was "⊚" (excellent).

### (Example 25)

The composite oxide sintered compact of Example 25 contained 45 mol% of TiO₂, ZrO₂ and HfO₂ with the ratio set at 1:1:1 based on the metal conversion of Ti, Zr and Hf. The carbon content was 23 ppm, hydrogen content was 24 ppm, relative density was 97%, maximum grain size was 28 µm, and average grain size was 15 µm. In the foregoing case, all conditions of the composite oxide sintered compact were within the scope of the preferred conditions of the present invention.

Consequently, no decay of the sintered compact into powder form could be acknowledged even in the 8^{th} week in a vessel with constant temperature (40°C) and constant humidity (90%) in the acceleration test. Moreover, in a vacuum pack, no pulverization was acknowledged even after the lapse of 1 year. It has been confirmed that when the existence of metals of Ti, Zr and Hf and the additional factors are within the conditions of the present invention as with this composite oxide sintered compact, an effect of inhibiting decay is yielded. The evaluation was "⊚" (excellent).

### (Comparative Example 1)

The oxide sintered compact of Comparative Example 1 was La₂O₃. The carbon content was 31 ppm, hydrogen content was 27 ppm, relative density was 96%, but the maximum grain size and average grain size could not be measured. In the foregoing case, after being left in the atmosphere for 2 weeks, it decayed into white powder form. In the foregoing case, it was not possible to maintain the shape of the sintered compact. The evaluation was "X" (inferior).

The foregoing results are shown in Table 1.

**[Table 1]**

| | Oxide | Content (Metal Conversion) (mol%) | Carbon (ppm) | Hydrogen (ppm) | Relative Density (%) | Maximum Grain Size (µm) | Average Grain Size (µm) | Equation Result | |
|---|---|---|---|---|---|---|---|---|---|
| Reference Example 1 | HfO₂ | 0.5 | 35 | 29 | 95 | 41 | 12 | Δ | Decayed into powder form in 3 weeks in atmosphere |
| Reference | Example 2 ZrO₂ | 0.5 | 23 | 19 | 97 | 37 | 9 | Δ | Decayed into powder form in weeks in atmosphere |
| Reference Example 3 | TiO₂ | 0.5 | 46 | 50 | 95 | 53 | 11 | Δ | Decayed into powder form in 3 weeks in atmosphere |
| Example 1 | HfO₂ | 1 | 37 | 30 | 95 | 40 | 10 | ○ | Decayed into powder form in 4 weeks in a constant temperature and humidity vessel |
| Example 2 | HfO₂ | 1 | 15 | 20 | 97 | 42 | 15 | ○ | Only surface pulverized in 4 weeks in a constant temperature and humidity vessel |
| Example 3 | HfO₂ | 5 | 53 | 47 | 97 | 41 | 5 | ○ | Decayed into powder form in 4 weeks in a constant temperature and humidity vessel |
| Example 4 | HfO₂ | 5 | 26 | 28 | 98 | 36 | 13 | O | Only surface pulverized in 4 weeks in a constant temperature and humidity vessel |
| Example 5 | HfO₂ | 10 | 76 | 28 | 95 | . 63 | 3 | ⊚ | Not pulverized in 8 weeks in a constant temperature and humidity vessel (hardness deteriorated) |
| Example 6 | HfO₂ | 10 | 18 | 20 | 96 | 23 | 15 | ⊚ | Not pulverized in 8 weeks in a constant temperature and humidity vessel |
| Example 7 | HfO₂ | 35 | 73 | 52 | 98 | 37 | 8 | ⊚ | Not pulverized in 8 weeks in a constant temperature and humidity vessel (hardness deteriorated) |
| Example 8 | HfO₂ | 35 | 13 | 21 | 98 | 30 | 13 | ⊚ | Not pulverized in 8 weeks in a constant temperature and humidity vessel |
| Example 9 | HfO₂ | 45 | 73 | 52 | 98 | 37 | 8 | ⊚ | Not pulverized in 8 weeks in a constant temperature and humidity vessel (hardness deteriorated) |
| Example 10 | HfO₂ | 45 | 10 | 25 | 98 | 31 | 14 | ⊚ | Not pulverized in 8 weeks in a constant temperature and humidity vessel |
| Example 11 | HfO₂ | 48 | 23 | 24 | 97 | 18 | 10 | ⊚ | Not pulverized in 8 weeks in a constant temperature and humidity vessel |
| Example 12 | ZrO₂ | 5 | 20 | 14 | 98 | 20 | 12 | ○ | Only surface pulverized in 4 weeks in a constant temperature and humidity vessel |
| Example 13 | ZrO₂ | 25 | 23 | 15 | 98 | 19 | 11 | ⊚ | Not pulverized in 8 weeks in a constant temperature and humidity vessel |
| Example 14 | ZrO₂ | 48 | 73 | 65 | 99 | 17 | 3 | ⊚ | Not pulverized in 8 weeks in a constant temperature and humidity vessel (hardness deteriorated) |
| Example 15 | TiO₂ | 1 | 37 | 30 | 95 | 40 | 10 | ○ | Decayed into powder form in 4 weeks in a constant temperature and humidity vessel |
| Example 16 | TiO₂ | 10 | 25 | 21 | 98 | 28 | 13 | ⊚ | Not pulverized in 8 weeks in a constant temperature and humidity vessel |
| Example 17 | TiO₂ | 30 | 25 | 21 | 98 | 28 | 13 | ⊚ | Not pulverized in 8 weeks in a constant temperature and humidity vessel |
| Example 18 | TiO₂ | 49 | 19 | 25 | 97 | 20 | 11 | ⊚ | Not pulverized in 8 weeks in a constant temperature and humidity vessel |
| Example 19 | TiO₂+ZrO₂ (1:1) | 10 | 20 | 23 | 97 | 19 | 9 | ⊚ | Not pulverized in 8 weeks in a constant temperature and humidity vessel |
| Example 20 | TiO₂+ZrO₂ (1:1) | 30 | 17 | 18 | 97 | 26 | 15 | ⊚ | Not pulverized in 8 weeks in a constant temperature and humidity vessel |
| Example 21 | TiO₂+HfO₂(1:1) | 20 | 18 | 19 | 97 | 23 | 12 | ⊚ | Not pulverized in 8 weeks in a constant temperature and humidity vessel |
| Example 22 | TiO₂+HfO₂ (1:1) | 40 | 25 | 20 | 97 | 23 | 17 | ⊚ | Not pulverized in 8 weeks in a constant temperature and humidity vessel |
| Example 23 | TiO₂+ZrO₂+HfO₂ (1:1:1) | 6 | 53 | 37 | 96 | 48 | 3 | ○ | Decayed into powder form in 4 weeks in a constant temperature and humidity vessel |
| Example 24 | TiO₂+ZrO₂+HfO₂ (1:1:1) | 24 | 23 | 24 | 97 | 23 | 16 | ⊚ | Not pulverized in 8 weeks in a constant temperature and humidity vessel |
| Example 25 | TiO₂+ZrO₂+HfO₂ (1:1:1) | 45 | 23 | 24 | 97 | 28 | 15 | ⊚ | Not pulverized in 8 weeks in a constant temperature and humidity vessel |
| Comparative Example 1 | None (only La₂O₃₎ | None | 31 | 27 | 96 | Not able to be measured | Not able to be measured | X | Decayed into white powder form in 2 weeks in atmosphere |
| Condition of Constant Temperature and Humidity Vessel =Temperature of 40°C, Humidity of 90% | | | | | | | | | |

| | | | | | | | | | |
|---|---|---|---|---|---|---|---|---|---|
| Evaluation Level × Decayed into white powder form in 2 weeks in atmosphere = Surface pulverized in 2 months in vacuum pack Δ Decayed into powder form in 3 weeks in atmosphere = Surface pulverized in 4 months in vacuum pack Δ Decayed into powder form in 4 weeks in atmosphere = Surface pulverized in 4 months in vacuum pack ○ Decayed into powder form in 4 weeks in a constant temperature and humidity vessel = Surface pulverized in 6 months in vacuum pack ○ Only surface pulverized in 4 weeks in a constant temperature and humidity vessel = Surface pulverized in 10 months in vacuum pack ⊚ Not pulverized in 8 weeks in a constant temperature and humidity vessel (hardness deteriorated) =Surface pulverized in 1 year in vacuum pack ⊚ Not pulverized in 8 weeks in a constant temperature and humidity vessel = Not pulverized in 1 year in vacuum pack | | | | | | | | | |

If a sputtering target of lanthanum oxide sintered compact is left out in the air for a long period of time, it reacts with moistures due to deliquescency and becomes covered with white hydroxide powder, and there is a problem in that normal sputtering cannot be performed. Moreover, it absorbs the carbon dioxide gas in the air and decays into the form of lanthanum carbonate powder. The target of the present invention enables to delay the occurrence of the foregoing problems, and can be stored for a period that will not cause problems in terms of practical use. In particular, the present invention is particularly useful as a lanthanum oxide-based sintered compact capable of efficiently and stably providing oxide for use in a high-k gate insulator film, a sputtering target composed of the foregoing sintered compact, a method of producing the lanthanum oxide-based sintered compact, and a method of producing the sputtering target based on the foregoing production method.

## Claims

1. A lanthanum oxide-based sintered compact having lanthanum oxide as a basic component, wherein the sintered compact contains one or more of titanium oxide, zirconium oxide and hafnium oxide with the remainder being lanthanum oxide and unavoidable impurities.

2. The lanthanum oxide-based sintered compact according to claim 1, wherein the amount of metal elements of titanium, zirconium and hafnium relative to the total component amount of metal elements in the sintered compact is 1 mol% or more and less than 50 mol%.

3. The lanthanum oxide-based sintered compact according to claim 1, wherein the amount of metal elements of titanium, zirconium and hafnium relative to the total component amount of metal elements in the sintered compact is 10 mol% or more and less than 50 mol%.

4. The lanthanum oxide-based sintered compact according to any one of claims 1 to 3, wherein hydrogen and carbon contents are respectively 25 wtppm or less, relative density is 96% or higher, maximum grain size is 50 µm or less, and average grain size is 5 µm or more.

5. A sputtering target composed of the sintered compact according to any one of claims 1 to 4.

6. A method of producing a lanthanum oxide-based sintered compact, wherein La₂(CO₃)₃ powder or La₂O₃ powder as lanthanum oxide raw material powder and one or more of TiO₂, ZrO₂ and HfO₂ powders as an additive oxide are used, blending and mixing are performed so that the composition ratio of metal components of the additive oxide relative to La becomes a predetermined value, the mixed powder is thereafter heated and synthesized in the atmosphere, the synthesized material is subsequently pulverized to obtain powder, and the synthesized powder is thereafter hot pressed into a sintered compact.

7. A method of producing the lanthanum oxide-based sintered compact according to any one of claims 1 to 5, wherein La₂(CO₃)₃ powder or La₂O₃ powder as lanthanum oxide raw material powder and one or more of TiO₂, ZrO₂ and HfO₂ powders as an additive oxide are used, blending and mixing are performed so that the composition ratio of metal components of the additive oxide relative to La becomes a predetermined value, the mixed powder is thereafter heated and synthesized in the atmosphere, the synthesized material is subsequently pulverized to obtain powder, and the synthesized powder is thereafter hot pressed into a sintered compact.

8. The method of producing the lanthanum oxide-based sintered compact according to claim 6 or claim 7, wherein the mixing is performed with a wet ball mill, and synthesys is performed by heating the mixed powder at 1350 to 1550°C for 5 to 25 hours in the atmosphere to produce the sintered compact.

9. The method of producing the lanthanum oxide-based sintered compact according to any one of claims 6 to 8, wherein the hot press is performed at 1200 to 1500°C in vacuum for 1 to 5 hours.

10. A method of producing a sputtering target based on the method of producing the lanthanum oxide-based sintered compact according to any one of claims 6 to 8.
